(19) Europäisches Patentamt / European Patent Office / Office européen des brevets

(11) **EP 3 037 449 A1**

(12) **EUROPÄISCHE PATENTANMELDUNG**

(43) Veröffentlichungstag: **29.06.2016 Patentblatt 2016/26**

(21) Anmeldenummer: **14199788.2**

(22) Anmeldetag: **22.12.2014**

(51) Int Cl.: *C08G 18/78* (2006.01) *C08G 18/80* (2006.01) *C08G 18/24* (2006.01) *C08G 18/32* (2006.01) *C08G 18/42* (2006.01) *H01L 41/00* (2013.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Covestro Deutschland AG**
**51373 Leverkusen (DE)**

(72) Erfinder: **Die Erfindernennung liegt noch nicht vor**

(74) Vertreter: **Levpat**
**c/o Covestro AG**
**Alfred-Nobel-Straße 10**
**40789 Monheim am Rhein (DE)**

# (54) Dipol-modifiziertes Polyurethan, Verfahren zu dessen Herstellung und Verwendung zur Herstellung von elektroaktiven Polyurethan-basierten Gießelastomerfolien

(57) Die vorliegende Erfindung betrifft ein Verfahren zur Herstellung eines dielektrischen Polyurethan-Polymers umfassend die Schritte:
(a) Erzeugung eines Dipol-funktionalisierten Polyisocyanats durch Umsetzung eines Polyisocyanats mit NCO-Funktionalität von > 2,0 mit einer Dipol-Verbindung der allgemeinen Formel (I)

$$(Z)\text{-}(R)_n\text{-}(D)\text{-}X\text{-}(A)_m \qquad \text{(Formel I)}$$

in der
Z eine funktionelle Gruppe mit wenigstens einem Zerewitinoff-aktiven Wasserstoffatom,
X ein organischer Rest mit einem delokalisierten Elektronensystem,
A eine Elektronenakzeptorfunktionalität, ausgewählt aus der Gruppe bestehend aus -N02, -CN, -F, -Cl, -CF3,-OCF3, Cyanovinyl-, Dicyanovinyl-, oder Tricyanovinyl-Resten,
D eine Elektronendonorfunktionalität, ausgewählt aus der Gruppe bestehend aus - O-, -S- oder -N(B)-, wobei B Wasserstoff oder ein linearer oder verzweigter Alkylrest mit 1 bis 16 Kohlenstoffatomen ist,
R ein Alkylenrest mit 1 bis 16 Kohlenstoffatomen repräsentiert, wobei
n = 0 oder 1 und m = 1, 2, 3 oder 4 ist;
(b) anschließende Umsetzung des nach Schritt (a) erhaltenen Dipol-funktionalisierten Polyisocyanats mit
(aa) einer Polyisocyanatkomponente und
(bb) einer Polyolkomponente.

Die Erfindung betrifft ferner ein nach dem Verfahren erzeugtes dielektrisches Polyurethan-Polymer sowie dessen Verwendung.



Printed by Jouve, 75001 PARIS (FR)

**Beschreibung**

Die vorliegende Erfindung betrifft ein Verfahren zur Herstellung eines dielektrischen Polyurethan-Polymers, ein nach dem Verfahren hergestelltes dielektrisches Polyurethan-Polymer, sowie dessen Verwendung alleine oder als Blend als Dielektrikum, als elastisches Dielektrikum, als Aktuator, als künstlicher Muskel, als Dielektrikum für flexible elektronische Bauteile, insbesondere Kondensatoren.

In an sich bekannten elektromechanischen Wandlern wird elektrische in mechanische Energie umgewandelt und umgekehrt. Sie können als Bestandteil von Sensoren, Aktoren und/oder Generatoren eingesetzt werden.

Derartige Wandler bestehen typischerweise aus elektroaktiven Polymeren (EAP). Das Aufbauprinzip und die Wirkungsweise sind dem eines elektrischen Kondensators ähnlich. Es gibt ein Dielektrikum zwischen zwei Platten unter Spannung. Allerdings handelt es sich bei EAPs um ein deformierbares Dielektrikum, welches sich im elektrischen Feld verformt. Genau genommen sind es dielektrische Elastomere meist in Folienform (DEAP; dielektrisches elektroaktives Polymer), welche einen hohen elektrischen Widerstand haben und beidseitig mit dehnbaren Elektroden hoher Leitfähigkeit beschichtet sind (Elektrode), wie beispielsweise in WO-A 01/06575 beschrieben. Dieser grundsätzliche Aufbau kann in unterschiedlichsten Konfigurationen zur Herstellung von Sensoren, Aktoren oder Generatoren eingesetzt werden. Neben einschichtigen Aufbauten sind auch mehrschichtige Aufbauten bekannt.

Gemeinsame mechanische Eigenschaften sind eine ausreichend hohe Bruchdehnung, niedrige bleibende Dehnungen und ausreichend hohe Druck-/Zug-Festigkeiten. Diese Eigenschaften sorgen für eine ausreichend große elastische Deformierbarkeit ohne mechanische Beschädigung des Energiewandlers. Für Energiewandler, die in Zug betrieben werden ist es besonders wichtig, dass diese Elastomere keine bleibende Dehnung aufweisen und unter mechanischer Last keine Spannungsrelaxation zeigen. Mit anderen Worten sollte ein Fließen, der so genannte "creep",nicht auftreten, da sonst nach einer bestimmten Zyklenzahl an Dehnungen kein EAP Effekt mehr vorhanden ist.

Es gibt aber auch je nach Anwendung divergierende Anforderungen: Für Aktoren im Zug-Modus werden hochreversibel dehnbare Elastomere mit hoher Bruchdehnung und niedrigem Zug-E-Modul benötigt. Für Generatoren, die in Dehnung betrieben werden, ist dagegen ein hoher Zug-E-Modul sinnvoll. Auch die Anforderungen an den Innenwiderstand sind unterschiedlich; für Generatoren werden deutlich höhere Anforderungen an den Innenwiderstand gestellt als für Aktoren.

Aus der Literatur ist für Aktoren bekannt, dass die Dehnbarkeit zur Dielektrizitätskonstante und der angelegten Spannung zum Quadrat sowie umgekehrt proportional zum Modul ist. Dieser Zusammenhang aus der relativen Dielektrizitätskonstante $\varepsilon_r$, der absoluten Dielektrizitätskonstante $\varepsilon_0$, dem Modul *Y*, der Foliendicke *d* und der Schaltspannung *U* mit der Dehnung $s_z$ ergibt sich aus der folgenden Gleichung 1

$$s_z = \frac{\sigma_{Maxwell}}{Y} = \frac{\varepsilon_0 \cdot \varepsilon_r}{Y}\left(\frac{U}{d}\right)^2$$

(Gleichung 1)

Die Dielektrizitätskonstanten und die Elektrische Feldstärke können dabei zum sogenannten MAXWELL-Druck $\sigma_{Marwell}$ zusammengefast werden. Die Spannung ist wiederum an die Durchbruchfeldstärke in der Weise gekoppelt, dass bei sehr niedriger Durchbruchbruchfeldstärke keine hohe Spannung angelegt werden kann. Da dieser Wert quadratisch in die Gleichung zur Berechnung der Dehnung eingeht, welche durch die elektromechanische Anziehung der Elektroden hervorgerufen wird, muss die Durchbruchfeldstärke entsprechend hoch sein. Eine typische Gleichung hierzu findet man in dem Buch von Federico Carpi, Dielectric Elastomers as Electromechanical Transducers, Elsevier, Seite 314, Gleichung 30.1 sowie ähnlich auch in R. Pelrine, Science 287, 5454, 2000, Seite 837, Gleichung 2. Bis jetzt bekannte Aktoren sind entweder in der Dielektrizitätskonstante und/oder der Durchbruchfeldstärke zu niedrig oder im Modul zu hoch. Nachteilig an bekannten Lösungen ist auch der niedrige elektrische Widerstand, der bei Aktoren zu hohen Leckströmen und im schlimmsten Fall zu einem elektrischen Durchschlag führt.

Für Generatoren ist wichtig, dass sie eine hohe elektrische Stromausbeute bei niedrigen Verlusten besitzen. Typische Verluste entstehen an Grenzflächen, beim Be- und Entladen des dielektrischen Elastomers sowie durch Leckströme durch das dielektrische Elastomer. Zusätzlich bewirkt der Widerstand der elektrisch leitfähigen Elektrodenschicht des EAPs einen Energieverlust. Die Elektrode sollte daher wiederum einen möglichst geringen elektrischen Innenwiderstand haben. Eine Beschreibung findet sich in einem Artikel von Christian Graf und Jürgen Maas, Energy harvesting cycles based on electro active polymers, proceedings of SPIE Smart structures, 2010, vol. 7642, 764217. Aus den Herleitungen gemäß Gleichung 34 und 35, folgt auf Seite 9 (12) letzter Satz, dass der Energieverlust minimal ist, wenn die Dielektrizitätskonstante sowie der elektrische Widerstand besonders hoch sind.

Da nahezu alle elektroaktiven Polymere unter zyklischen Belastungen und vorgedehnten Strukturen betrieben

werden, dürfen die Materialien bei wiederholten zyklischen Belastungen nicht zum Fließen neigen und der "creep" sollte daher so gering wie möglich sein.

Die Permittivität heutiger Elastomere ist jedoch in der Regel auf Werte von bis zu 6 beschränkt. Dadurch ergeben sich für aus diesen Materialien gefertigte künstliche Muskeln und Aktorikelemente Schaltspannungen von in der Regel > 1 kV. Diese hohen Schaltspannungen setzen der Anwendbarkeit dieser Technologie enge Grenzen. Daher sind verschiedene technische Vorschläge und Lösungen unterbreitet worden, die zu einer deutlichen Anhebung der Permittivität führen. So kann durch Blenden der genannten Polymere mit Nanopartikeln hochpermittiver anorganischer Materialien, wie Bariumtitanat, Bleizirkonat, Titandioxid u.a., die Permittivität der Elastomere deutlich erhöht werden, so dass niedrigere Schaltspannungen von einigen hundert Volt erreicht werden können. Diese Lösungen beinhalten jedoch deutliche Nachteile, die in einer wesentlichen Verschlechterung der Verarbeitungseigenschaften, in einer Veränderung der mechanischen Eigenschaften der Elastomere (Versteifung) und in Problemen der homogenen Verteilung der Nanopartikel in der Elastomermatrix liegen. Nanopartikel können aggregieren, agglomerieren und zu Problemen bei der Bildung homogener Elastomerfilme führen. Weiterhin sind Nanopartikel der genannten anorganischen Materialien durch ihre hohe innere Oberfläche in der Regel hochreaktiv und können somit zu einer Destrukturierung oder einer Schädigung der Elastomermatrix führen. Weiterhin stellen die Wechselwirkungen an der Grenzfläche Nanopartikel/Elastomermatrix ein häufiges, nicht einfach zu lösendes Problem bei der Anwendung von Nanopartikeln zur Erhöhung der Permittivität von dielektrischen Elastomeren dar.

Es wurde ferner der Versuch unternommen, existierende Elastomere durch das Hinzufügen von weiteren Komponenten, wie Füllpartikeln, zu modifizieren. Hierfür wurden elektrisch nicht leitfähige und leitfähige Partikel benutzt. Der Vorteil der Einfachheit der Modifizierung von bereits existierenden Elastomeren hat zu vielen unterschiedlichen Herangehensweisen in der Materialforschung geführt.

Als keramische, dielektrische Partikel können TiO2, BaTiO3, PMN-PT (Blei-Magnesium-Niobat mit Bleititanat) oder andere Materialien verwendet werden. Diese Keramiken sind für ihre hohen Permittivitäten bekannt, die typischerweise mehrere Größenordnungen größer sind als die Permittivität des amorphen Elastomers. Das direkte Dispergieren der Partikel hat zu divergierenden Ergebnissen geführt. Es wurden zum Einen Verbesserungen und zum Anderen Verschlechterungen in der maximalen Aktorauslenkung erzielt. Dies ist auf die relativ geringe Erhöhung der Permittivität des Komposits und der gleichzeitigen starken Erhöhung des Elastizitätsmoduls durch die Partikelzugabe zurückzuführen.

Eine Möglichkeit der Senkung des Elastizitätsmoduls ist die Zugabe von Weichmachern. Die Verwendung von Tensiden führt zu einer verbesserten Dispersion der Partikel und verhindert deren Agglomeration. Somit können auch Partikel mit einem Durchmesser von nur 15 nm verwendet werden. Die schlechte Beschaffenheit der meisten Komposite führte jedoch dazu, dass mögliche Anwendungen dieser Materialien als Aktoren nicht weiter verfolgt wurden.

Die Verwendung elektrisch leitfähiger Partikel ist ebenfalls bekannt (Q. M. Zhang, H. Li, M. Poh, F. Xia, Z.-Y. Cheng, H. Xu, and C. Huang, \An all-organic composite actuator material with a high dielectric constant," Nature 419, pp. 284{287, 2002.). In ersten Versuchen wurden Farbstoffe und leitfähige Polymere verwendet. Eine spätere Veröffentlichung (C. Huang and Q. Zhang, \Fully functionalized high-dielectric-constant nanophase polymers with high electromechanical response," Adv. Mater 17, p. 1153, 2005. Doi: 10.1002/adma.200401161.) ließ Zweifel bezüglich der Permittivitätserhöhung aufkommen. Die Erhöhung der Permittivität in CuPc-PU-Kompositen z.B. war die Folge einer unvollständigen chemischen Reaktion. Eine Arbeit, die auf der zufälligen Verteilung von elektrisch leitfähigen Carbon Black-Partikeln in einem thermoplastischen Elastomer basiert, führte zu einer starken Erhöhung der Permittivität aber auch gleichzeitig zu einer stark verminderten Durchbruchsfeldstärke. In einer anderen Arbeit wurde ein halbleitendes Polymer (Poly(3-hexylthiophen)) mit einem chemisch verlinkenden Silikon vermischt. Daraus resultierte eine Erhöhung der Permittivität sowie eine Verminderung des Elastizitätsmoduls. In allen zuvor erwähnten Fällen wurde neben den erzielten Verbesserungen auch immer die Durchbruchsfeldstärke stark verringert. Dies begrenzt sehr stark die maximale Aktorauslenkung.

In WO 2012/038093 werden Dipol-Moleküle mit einer elektronenziehenden und einer elektronenschiebenden Struktureinheit an ein Polymer gebunden. Solche Dipol-Moleküle werden auch als "push-pull"-Moleküle" bezeichnet. Bei dem hier beschriebenen Verfahren kann es als nachteilig empfunden werden, dass sie die Dipol-Moleküle unkontrolliert in das Polymer eingebaut werden und hierbei die Polymerstruktur negativ beeinflussen können. Die Moleküle wirken als Kettenverlängerer und erhöhen neben dem Modul des Elastomers auch den Glaspunkt was zu duroplastischen nicht elastomeren Polymeren im Falle der Polyurethane wirkt. Gerade bei Polyurethan Elastomeren für elektroaktiven Polymere liegt die Glasübergangstemperatur meist um die Null Grad. Eine weitere Erhöhung führt zu einem Verlassen des Gebrauchstemperaturbereiches, das heißt eine Glasübergangstemperatur oberhalb der Raumtemperatur.

Im Stand der Technik sind Wandler beschrieben, welche verschiedene Polyurethane als Bestandteil der elektroaktiven Schicht enthalten, wie beispielsweise in WO 2012/038093 A1. Nachteilig an Polyurethan-basierten Wandlern ist, dass im Falle der Polyetherpolyol-basierten dielektrischen Polyurethan-Filme der elektrische Widerstand sowie die Durchbruchsfeldstärke zu niedrig sind. Im Falle der Polycarbonatpolyol- und Polyesterpolyol-basierten Wandler liegt die Glasübergangstemperatur bei > 0°C so dass die Wandler nur eingeschränkt bei typischen Umgebungstemperaturen betrieben werden können. Nachteilig ist ferner, dass die Dielektrizitätskonstante bei den vorgenannten Typen sehr

niedrig ist, so dass der Wandler bei hoher elektrischen Spannungen betrieben werden muss. Die verwendete Hochspannungselektronik ist jedoch sehr teuer und macht eine breite Nutzung der elektromechanischen Wandler in vielen Anwendungsbereichen unwirtschaftlich.

Der vorliegenden Erfindung lag somit die Aufgabe zugrunde, ein Verfahren zur Herstellung eines dielektrischen Polyurethan-Polymers zur Verfügung zu stellen, das die Erzeugung eines Polymers ermöglicht, das sich gut zu Polymerfolien verarbeiten lässt und das eine hohe Dielektrizitätskonstante bei gleichzeitig niedrigem Elastizitätsmodul aufweisen soll, sodass die Dehnunc, $s_z$ gemäß der obigen Gleichung 1 verbessert wird.

Die erfindungsgemäße Aufgabe wird gelöst durch ein Verfahren zur Herstellung eines dielektrischen Polyurethan-Polymers umfassend die Schritte:

(a) Erzeugung eines Dipol-funktionalisierten Polyisocyanats durch Umsetzung eines Polyisocyanats mit NCO-Funktionalität von > 2,0 mit einer Dipol-Verbindung der allgemeinen Formel (I)

$$(Z)\text{-}(R)_n\text{-}(D)\text{-}X\text{-}(A)_m \qquad \text{(Formel I)}$$

in der
Z eine funktionelle Gruppe mit wenigstens einem Zerewitinoff-aktiven Wasserstoffatom,
X ein organischer Rest mit einem delokalisierten Elektronensystem,
A eine Elektronenahzeptorfunktionalität, ausgewählt aus der Gruppe bestehend aus -NO2, -CN, -F, -Cl, -CF3,-OCF3, Cyanovinyl-, Dicyanovinyl-, oder Tricyanovinyl-Resten,
D eine Elektronendonorfunktionalität, ausgewählt aus der Gruppe bestehend aus -O-, -S- oder-N(B)-, wobei B Wasserstoff oder ein linearer oder verzweigter Alkylrest mit 1 bis 16 Kohlenstoffatomen ist,
R ein Alkylenrest mit 1 bis 16 Kohlenstoffatomen repräsentiert, wobei
n = 0 oder 1 und m = 1, 2, 3 oder 4 ist;

(b) anschließende Umsetzung des nach Schritt (a) erhaltenen Dipol-funktionalisierten Polyisocyanats mit

(aa) einer Polyisocyanatkomponente und
(bb) einer Polyolkomponente.

Der vorliegenden Erfindung liegt die Erkenntnis zugrunde, dass durch die Verwendung eine in einem ersten Verfahrensschritt hergestellten Dipol-funktionalisierten Polyisocyanats, welches in Form eines reaktiven Additivs einem üblichen Reaktionssystem zur Erzeugung eines Polyisocyanats zugesetzt werden kann, ein dielektrisches Polyurethan-Polymer herstellbar ist, dass sich durch eine hohe Dielektrizitätskonstante bei gleichzeitig niedrigem Elastizitätsmodul auszeichnet. Dadurch, dass die Dipol-Verbindung der Formel (I), also die eigentliche "push-pull"-Fuktionalität isocyanatmodifiziert wird, kann das erhaltene Dipol-funktionalisierte Polyisocyanat als weiteres Polyisocyanat an der üblichen Umsetzung mit Polyolverbindungen teilnehmen.

Hierdurch wird die "push-pull"-Funktionalität (push = elektronendonierende Gruppe, pull = elektronenziehende Gruppe) gleichmäßig und gezielt während des Molekülkettenaufbaus in der entstehenden Polyurethan-Kette eingebaut. Dadurch wirkt das Dipol-funktionalisierte Polyisocyanat auch nicht als Kettenverlängerer, sodass auch keine ungewollte Erhöhung der Glasübergangstemperatur auftritt. Da das Dipol-funktionalisierte Polyisocyanat in die Molekülkette eingebaut wird, treten zudem die bei nicht-reaktiven Additiven auftretenden Probleme der Migration nicht auf. Auch die mit der Verwendung von partikulären Additiven verbundenen Nachteile hinsichtlich der mechanischen Eigenschaften treten vorliegend nicht auf.

Ein weiterer Vorteil besteht darin, dass die Auswirkung des Dipol-funktionalisierten Polyisocyanats auf den Vernetzungsgrad gesteuert werden kann, indem die NCO-Funktionalität des für die Herstellung des Dipol-funktionalisierten Polyisocyanats verwendeten Polyisocyanats und die Menge der Dipol-Verbindung der allgemeinen Formel (I) angepasst werden. Dabei wird typischerweise im Rahmen der vorliegenden Erfindung in der Weise vorgegangen, dass die NCO-Funktionalität des Dipol-funktionalisierten Polyisocyanats nach der Umsetzung eines Polyisocyanats mit NCO-Funktionalität von > 2,0 mit einer Dipol-Verbindung der allgemeinen Formel (I) bei wenigstens 2,0 liegt. Die NCO-Funktionalität wird, wenn nicht ausdrücklich anders erwähnt, volumetrisch gemäß DIN EN ISO 11909 bestimmt.

Unter einem Zerewitinoff-aktiven Wasserstoffatom wird im Rahmen der vorliegenden Erfindung ein azides H-Atom oder "aktives" H-Atom verstanden. Ein solches kann in an sich bekannter Weise durch eine Reaktivität mit einem entsprechenden Grignard-Reagenz identifiziert werden. Die Menge an Zerewitinoff-aktiven Wasserstoffatomen wird typischerweise über die Methanfreisetzung gemessen, die bei einer Reaktion der zu überprüfenden Substanz mit Methylmagnesiumbromid ($CH_3$-MgBr) gemäß der folgenden Reaktionsgleichung (Formel 2) frei wird:

$$CH_3\text{-}MgBr + ROH \rightarrow CH_4 + Mg\ (OR)Br \qquad \text{(Formel 2)}$$

Zerewitinoff-aktive Wasserstoffatome stammen typischerweise von C-H aziden organischen Gruppen. Typischerweise steht Z für OH, COOH, SH oder $NH_2$.

In der Formel (I) handelt es sich bei der Gruppe X um einen organischen Rest mit einem delokalisierten Elektronensystem. Ein delokalisiertes Elektronensystem ist beispielsweise ein solches mit einem delokalisierten PI-Elektronensystem. Hierdurch wird eine Delokalisierung der Elektronen zwischen D und A ermöglicht. Typische Vertreter der Gruppe X sind beispielsweise eine Phenylengruppe, eine Naphthylengruppe, konjugierte Aromaten, wie beispielsweise Biphenyle, Stilbene, Azobenzene, Terphenyle, oder analoge hetroaromatische Systeme.

Der nach dem erfindungsgemäßen Verfahren hergestellte dielektrische Polyurethan Film weist eine gute mechanische Festigkeit und eine hohe Elastizität auf. Weiterhin hat er gute elektrische Eigenschaften wie eine hohe Durchbruchsfeldstärke, einen hohen elektrischen Widerstand und eine hohe Dielektrizitätskonstante und kann daher vorteilhaft in einem elektromechanischen Wandler mit hohem Wirkungsgrad eingesetzt werden.

Als Polyisocyanatkomponente kann jedes an sich zur Herstellung von Polyurethanen bekannte organische Polyisocyanat eingesetzt werden oder aber auch beliebige Mischungen von organischen Polyisocyanaten. Diese werden im Folgenden noch näher spezifiziert.

Als Polyolkomponente kann analog jedes an sich zur Herstellung von Polyurethanen bekannte Polyol eingesetzt werden oder aber auch beliebige Mischungen von Polyolen. Diese werden im Folgenden noch näher spezifiziert. Vorteilhafterweise ist die Polyolkomponente ausgewählt aus der Gruppe bestehend aus Polyesterpolyolen, Polycarbonatpolyolen und Polyestercarbonatpolyolen.

Nach einer Weiterbildung des erfindungsgemäßen Verfahrens beträgt der Gehalt des Dipol-funktionalisierten Polyisocyanats bezogen auf die Gesamtmasse aus Dipol-funktionalisierten Polyisocyanat, Polyisocyanatkomponente und Polyolkomponente 0,1 bis 50 Gew.-%, insbesondere 1 bis 20 Gew.-%, bevorzugt 5 bis 10 Gew.-%.

In bevorzugter Ausgestaltung des erfindungsgemäßen Verfahrens kann R ein Alkylenrest mit 2 bis 8 Kohlenstoffatomen sein, insbesondere mit 2 oder 3 Kohlenstoffatomen.

Bei dem erfindindungsgemäßen Verfahren kann die Summe der zahlenmittleren Funktionalität an Isocyanat-Gruppen und Isocyanat-reaktiven Gruppen in der Polyisocyanatkomponente (aa) und der Polyolkomponente (bb) $\geq 2,3$ und $\leq 6$ sein.

Die "zahlenmittlere Funktionalität" im Sinne der vorliegenden Erfindung wird wie folgt veranschaulicht. Die höhere funktionale Verbindung ist hierbei entscheidend, wobei die Differenz der niedriger funktionalen Verbindung minus 2 zur höher funktionalen Verbindung addiert wird. Hat beispielsweise (bb) eine (durchschnittliche) Funktionalität von 2,1 und (aa) von 2,6 so gilt: 2,1-2=0,1. Diese Differenz wird 2,6 zugerechnet: 2,6 + 0,1 = 2,7. So ist die zahlenmittlere Funktionalität 2,7. Alternativ: wenn (bb) 2,7 und (aa) 2,3 ist, so gilt zahlenmittlere Funktionalität = 2,7 + 2,3-2 = 3,0.

Bei dem erfindungsgemäßen Verfahren ist es des Weiteren bevorzugt, dass das Polyisocyanat zur Herstellung des Dipol-funktionalisierten Polyisocyanats und die Polyisocyanatkomponente (aa) unabhängig voneinander eine NCO-Funktionalität von 2,6 bis 4,2 besitzen, insbesondere von 2,8 bis 4,0, bevorzugt von 2,8 bis 3,8. Dies ist von Vorteil, da auf diese Weise der Quervernetzungsgrad des zu erzeugenden Polyurethans eingestellt werden kann, was beispielsweise Auswirkungen auf das Kriechverhalten hat.

Wie bereits vorstehend ausgeführt wurde, besitzt das Dipol-funktionalisierte Polyisocyanat in der Regel eine NCO-Funktionalität von wenigstens 2,0. Vorzugsweise beträgt die NCO-Funktionalität 2,1 bis 4,0, weiter bevorzugt von 2,5 bis 3,0.

Nach einer besonders bevorzugten Ausgestaltung des erfindungsgemäßen Verfahrens entspricht die Dipol-Verbindung der allgemeinen Formel II

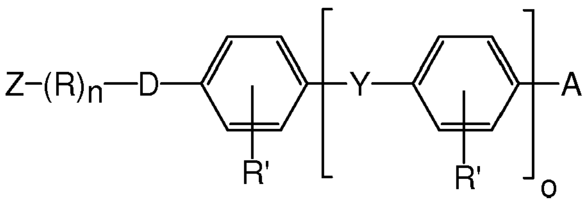

(Formel II)

in der

A, D, R, Z und n die oben angegebene Bedeutung haben,

R' jeweils unabhängig ausgewählt ist aus der Gruppe bestehend aus Wasserstoff, linearen oder verzweigten Alkylresten mit 1 bis 18 Kohlenstoffatomen sowie aromatischen Resten,

Y eine chemische Bindung repräsentiert oder ausgewählt ist aus der Gruppe bestehend aus cis- oder trans-1,2-Ethendiyl,

Ethindiylresten, einer Diazogruppe oder einer 1,2-Azomethindiylgruppe, sowie

o = 0 bis 10, insbesondere 1, 2 oder 3 ist. Dies ist vorteilhaft, weil diese pushpull-Gruppen die Dielekrizitätskonstante von daraus erzeugten Polyurethanen stark anheben.

Bei dem Erfindungsgemäßen Verfahren kann in der Weise Verfahren werden, dass das nach Schritt (a) erhaltene Dipol-funktionalisierte Polyisocyanat

- unmittelbar mit der Polyisocyanatkomponente (aa) und der Polyolkomponente (bb) oder
- zunächst mit der Polyolkomponente (bb) oder einer Teilmenge der Polyolkomponente (bb) umgesetzt und das dabei erhaltene Präpolymer anschließend mit der Polyisocyanatkomponente (aa) sowie gewünschtenfalls der restlichen Teilmenge der Polyolkomponente (bb)

umgesetzt wird. Damit wird die Möglichkeit eröffnet, entweder im "one-shot"-Verfahren alles Komponenten unmittelbar zu mischen und miteinander umzusetzen oder zunächst ein Präpolmer herzustellen, welches dann in einem nachgelagerten Schritt mit der Polyisocyanatkomponente (aa) und der restlichen Teilmenge der Polyolkomponente (bb) zur Reaktion gebracht wird. Hierbei kann das so hergestellt Präpolymer direkt weiter verarbeitet oder erst abgefüllt und gelagert werden und später eingesetzt werden.

Unabhängig davon, wie die Komponenten miteinander umgesetzt werden, können die an sich für diese Reaktionen dem Fachmann bekannten Polymerisationskatalysatoren eingesetzt werden, beispielsweise Dibutylzinndilaurat oder dergleichen.

Die Erfindung betrifft weiterhin ein dielektrisches Polyurethan-Polymer erhältlich oder erhalten nach dem erfindungsgemäßen Verfahren. Das dielektrische Polyurethan-Polymer besitzt bevorzugt eine, mehrere oder sämtliche der folgenden Eigenschaften:

a. Einen Zugmodul von < 5 MPa bei 25% Dehnung nach DIN 53 504;

b. eine Bruchdehnung von > 20% nach DIN 53 504, insbesondere > 50%, bevorzugt > 80%;

c. eine Spannungsrelaxation (Creep) gemäß DIN 53 441 bei 10% Deformation nach 30 min nach DIN 53 441 von < 20%, insbesondere < 15%, bevorzugt < 10%;

d. eine Durchbruchfeldstärke von > 40 V/μm nach ASTM D 149-97a, insbesondere > 60 V/μm, bevorzugt > 80 V/μm;

e. einen elektrischen Widerstand von > 1,0 E10 Ohm m nach ASTM D 257, insbesondere > 1,0 E11 Ohm m, bevorzugt > 5,0 E11 Ohm m;

f. eine Dielektrizitätskonstante von > 8 bei 0,01 - 1 Hz nach ASTM D 150-98;

g. eine Knotendichte > 0,13 mol/kg und < 1,5 mol /kg;

h. eine Energiedichte > 0,2 J/cm$^3$;

i. eine Dielektrizitätskonstante nach ASTM D 150-98 bei 1 Hz von wenigstens 8, insbesondere von 8 bis 15;

j. eine elektrische Durchschlagfestigkeit von wenigstens 80 V/μm nach ASTM D 149-97a, insbesondere von 80 bis 230;

k. einen elektrischen Volumenwiderstand von wenigstens 1 E11 V/cm nach ASTM D 257, insbesondere von 1,0 E11 V/cm bis 8,0 E16 V/cm;

l. einen Creep gemäß DIN 53 441 von wenigstens 12%, insbesondere von 0.15 bis 12.

Unter der "Knotendichte" des dielektrischen Polyurethan-Polymers (Einheit: [mol/kg]) wird die Anzahl der dreiwertigen, permanenten chemischen Vernetzungsstellen des Polyurethanelastomeren in Mole pro Kilogramm Polyurethan-Polymer verstanden. Hierzu werden die Stoffmengen aller Moleküle der Ausgangsrohstoffe des Polyurethan-Polymers mit einer höheren Funktionalität als 2 erfasst. Um alle Vernetzungsstellen wie trifunktionelle Vernetzungsstellen behandeln zu können, werden die Funktionalitäten höherfunktioneller Molekülsorten unterschiedlich gewichtet: trifunktionelle Moleküle werden mit 1 gewichtet, tetrafunktionelle mit 2, pentafunktionelle mit 3, hexafunktionelle mit 4 u.s.w. Nach dieser Definition hätte ein Polyurethan aus den äquivalent verschäumten Komponenten Polyesterdiol, 1,4-Butandiol, Triethanolamin, Pentaerythrit mit einem Gemisch aus 1,21 Gew.-% 2,4'-Diphenylmethandiisocyanat und 98,79 Gew.% 4,4'-Diphenylmethandiisocyanat eine Knotendichte von 0,69 mol/kg. Zur Berechnung wird auch auf EP 1 556 429 B1 verwiesen, insbesondere auf den Abschnitt [0017].

Ein weiterer Gegenstand der vorliegenden Erfindung betrifft die Verwendung eines erfindungsgemäßen dielektrischen Polyurethan-Polymers oder eines Blends aus diesem dielektrischen Polyurethan-Polymer und wenigstens einem weiteren Polymer ausgewählt aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten, als Dielektrikum, als elastisches Dielektrikum, als Aktuator, als künstlicher Muskel, als Dielektrikum für flexible elektronische Bauteile, insbesondere Kondensatoren, insbesondere weiche Kondensatoren.

Die Erfindung betrifft zudem einen Formkörper in Form eines Dielektrikums, eines künstlichen Muskels und/oder eines Aktuators, wie vorgestreckte Aktuatoren und/oder Stapelaktuatoren, wobei der Formkörper ein erfindungsgemäßes dielektrisches Polyurethan-Polymer oder ein Blend aus diesem erfindungsgemäßen dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Ein weiterer Gegenstand der vorliegenden Erfindung ist ein elektrochemischer Wandler, enthaltend ein erfindungsgemäßes dielektrisches Polyurethan-Polymer oder oder ein Blend aus diesem erfindungsgemäßen dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Bei einem elektromechanischen Wandler ist die Elektrodenschicht auf den Lagen vorzugsweise so aufgebracht, dass sie von den Seiten kontaktiert werden kann und nicht über dem dielektrischen Filmrand steht, da es sonst zu Durchschlägen kommt. Gängigerweise lässt man hier zwischen Elektrode und Dielektrikum einen Sicherheitsrand, so dass die Elektrodenfläche kleiner als die Dielektrikumsfläche ist. Die Elektrode ist so strukturiert, dass eine Leiterbahn zur elektrischen Kontaktierung heraus geführt wird.

Der Wandler kann vorteilhaft in unterschiedlichsten Konfigurationen zur Herstellung von Sensoren, Aktoren und/oder Generatoren eingesetzt werden. Ein weiterer Gegenstand der vorliegenden Erfindung ist daher eine elektronische und/oder elektrische Vorrichtung, insbesondere ein Baustein, Automat, Instrument oder eine Komponente, umfassend einen erfindungsgemäßen elektromechanischen Wandler.

Ferner betrifft die vorliegende Erfindung die Verwendung eines erfindungsgemäßen elektromechanischen Wandlers in einer elektronischen und/oder elektrischen Vorrichtung, insbesondere in einem Aktor, Sensor oder Generator. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von mechanischer Energie, insbesondere aus rotierenden oder ggf. auch statistisch oszillierenden Bewegungen, in elektrische Energie.

Unter einem Polyesterpolyol wird ein durch Polykondensation hergestelltes, im Wesentlichen Hydroxylendgruppen aufweisendes Reaktionsprodukt verstanden. Polycarbonatpolyole sind analog aufgebaute Polyester der Kohlensäure. Polyestercarbonatpolyole sind polymere Polyole die Estereinheiten sowohl mit organischen Säuren als auch mit Kohlensäure aufweisen.

Zahlenmittlere Funktionalitäten der isocyanat-reaktiven Verbindung werden rechnerisch dadurch bestimmt, dass man bei einer beliebigen Polyesterpolyolrezeptur zunächst die Anzahl der Moleküle vor Beginn der Reaktion bestimmt. Weiterhin wird die Molzahl an Hydroxylgruppen aller Polyole vor Beginn der Umsetzung ebenso bestimmt, wie die Molzahl an Carboxylgruppen. Bei Verwendung von Carbonsäureanhydriden und/oder Estern aus (zumeist niedermolekularen, monofunktionallen Alkoholen) ergibt sich diese Molzahl an Carboxylgruppen dadurch, dass man Anhydride und/oder Ester gedanklich zu Carbonsäuren hydrolysiert.

Vorteilhaft ist, wenn die Polylkomponente, im Folgenden kurz als Polyol bezeichnet, eine zahlenmittlere Funktionalität an Isocyanat-reaktiven Gruppen von $\geq$ 1,5 und $\leq$ 6, ganz besonders bevorzugt $\geq$ 1,6 und $\leq$ 4,4 und ganz besonders bevorzugt $\geq$ 1,6 und $\leq$ 3,4, besonders bevorzugt $\geq$ 1,6 und $\leq$ 2,8 aufweist.

Als Polyisocyanatkomponente (aa) sowie auch als Polyisocyanat zur Erzeugung eines Dipol-funktionalisierten Polyisocyanats eignen sich erfindungsgemäß beispielsweise 1,4-Butylendiisocyanat, 1,6 Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane (H12-MDI) oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4- und/oder 2,6-Toluylendiisocyanat (TDI), 1,5-Naphthylendiisocyanat, 2,2'- und/oder 2,4'- und/oder 4,4'-Diphenylmethandiisocyanat (MDI), 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Modifizierungen wie etwa Allophanat-, Uretdion-, Urethan-, Isocyanurat-, Biuret-, Iminooxadiazindion- oder Oxadiazintrionstruktur enthaltende Verbindungen basierend auf den genannten Diisocyanaten geeignete Bausteine der Komponente a) sowie mehrkernige Verbindungen wie beispielsweise polymeres MDI (pMDI) sowie Kombinationen von allen. Bevorzugt werden Modifizierungen mit einer Funktionalität von 2 bis 6, bevorzugt von 2,0 bis 4,5 und besonders bevorzugt von 2,6 bis 4,2 und besonders bevorzugt von 2,8 bis 4,0 und ganz besonders bevorzugt von 2,8 bis 3,8 eingesetzt.

Besonders bevorzugt werden zur Erzeugung eines Dipol-funktionalisierten Polyisocyanats Diisocyanate aus der Reihe HDI, IPDI, $H_{12}$-MDI, TDI und MDI verwendet. Besonders bevorzugt wird HDI eingesetzt. Ganz besonders bevorzugt wird ein Polyisocyanat auf HDI-Basis mit einer Funktionalität von > 2,3 eingesetzt. Besonders bevorzugt werden Biurete, Allophanate, Isocyanurate sowie Iminooxadiazindion- oder Oxadiazintrionstruktur eingesetzt, ganz besonders bevorzugte Biurete. Der bevorzugte NCO Gehalt liegt > 3 Gew.-%, besonders bevorzugt > 10 Gew.-%, besonders bevorzugt > 15 % und ganz besonders bevorzugt > 18 Gew.-%. Der NCO Gehalt ist ≤ 51 Gew.-%, bevorzugt < 40 Gew.-% ganz besonders bevorzugt < 35 Gew.-%, ganz besonders bevorzugt < 30 Gew.-% und ganz besonders bevorzugt < 25 Gew.-%. Besonders bevorzugt liegt der NCO Gehalt zwischen 18 und 25 Gew.-%. Ganz besonders bevorzugt werden als a) modifizierte aliphatische Isocyanate auf HDI Basis mit einem freien, unreagierten monomeren Anteil an freiem Isocyanat von < 0.5 Gew.-% verwendet.

Wenn im Folgenden hinsichtlich der Isocyanate nicht explizit zwischen der Polyisocyanatkomponente (aa) und dem Polyisocyanat zur Erzeugung eines Dipol-funktionalisierten Polyisocyanats differenziert wird, gelten die Ausführungen für beide Isocyanate.

Es können die Isocyanatgruppen auch partiell oder ganz bis zu ihrer Reaktion mit der isocyanatreaktiven Gruppen blockiert vorliegen, so dass sie nicht unmittelbar mit der isocyanat-reaktiven Gruppe reagieren können. Dies gewährleistet, dass die Reaktion erst bei einer bestimmten Temperatur (Blockierungstemperatur) stattfindet. Typische Blockierungsmittel finden sich im Stand der Technik und sind so ausgewählt, dass sie bei Temperaturen zwischen 60 und 220 °C, je nach Substanz, von der Isocyanat-Gruppe wieder abspalten und die erst dann mit der isocyanat-reaktiven Gruppe reagieren. Es gibt Blockierungsmittel, die in das Polyurethan eingebaut werden und auch solche, die als Lösemittel bzw. Weichmacher im Polyurethan bleiben oder aus dem Polyurethan ausgasen. Man spricht auch von blockierten NCO-Werten. Ist in der Erfindung von NCO-Werten die Rede, so ist dies immer auf den unblockierten NCO-Wert bezogen. Meist wird bis zu < 0,5% blockiert. Typische Blockierungsmittel sind beispielsweise Caprolactam, Methylethylketoxim, Pyrazole wie beispielsweise 3,5-Dimethyl-1,2-pyrazol oder 1,-Pyrazol, Triazole wie beispielsweise 1,2,4-Triazol, Diisopropylamin, Diethylmalonat, Diethylamin, Phenol oder dessen Derivate oder Imidazol.

In einer weiteren Ausführungsform des erfindungsgemäßen Verfahrens umfasst die Polyisocyanatkomponente (aa) ein Biuret und/oder Isocyanurat von Hexamethylendiisocyanat. Die Isocyanat-reaktiven Gruppen der Polyolkomponente (bb) sind funktionelle Gruppen, die unter Ausbildung kovalenter Bindungen mit Isocyanat-Gruppen reagieren können. Insbesondere kann es sich hierbei um Amin-, Epoxy-, Hydroxyl-, Thiol-, Mercapto-, Acryl-, Anhydrid-, Vinyl-, und/oder Carbinol-Gruppen handeln. Besonders bevorzugt handelt es sich bei den Isocyanat reaktive Gruppen um Hydroxyl- und / oder Amin-Gruppen.

Die Polyolkomponente (bb) kann bevorzugt eine OH-Zahl ≥10 und ≤150, und bevorzugt eine OH-Zahl ≥27 und ≤150, besonders bevorzugt > 27 und ≤ 120 mg KOH/g aufweisen.

Vorteilhaft ist, wenn die Polyolkomponente (bb) eine zahlenmittlere Funktionalität an Isocyanat-reaktiven Gruppen von ≥ 1,5 und ≤ 6, ganz besonders bevorzugt ≥ 1,6 und ≤ 4,4 und ganz besonders bevorzugt ≥ 1,6 und ≤ 3,4, besonders bevorzugt ≥ 1,6 und ≤ 2,8 aufweist, wobei die Isocyanat-reaktiven Gruppen bevorzugt Hydroxyl und / oder Amin sind.

Bevorzugt ist weiterhin, wenn es sich bei der isocyanat-reaktiven Gruppe der Polyolkomponente (bb) um ein Polymer handelt.

Gemäß einer vorteilhaften Ausführungsform des erfindungsgemäßen Verfahrens ist vorgesehen, dass die Polyolkomponente (bb) ein Polyesterpolyol und / oder ein Polycarbonatpolyol umfasst oder daraus besteht und besonders bevorzugt ein Polyesterdiol und / oder ein Polycarbonatdiol umfasst oder daraus besteht. Die Polyolkomponente (bb) kann weniger bevorzugt ein Polyetherpolyol, Polyetheramin, Polyetheresterpolyol, Polyethercarbonatpolyol, ein Polybutadienderivat, ein Polysiloxan oder eine Mischungen davon sein. Bevorzugt umfasst die Polyolkomponente (bb) jedoch ein Polyol mit mindestens zwei isocyanat-reaktiven Hydroxylgruppen oder besteht daraus. Geeignete Polyesterpolyole können Polykondensate aus Disowie gegebenenfalls Tri- und Tetraolen und Di- sowie gegebenenfalls Tri- und Tetracarbonsäuren oder Hydroxycarbonsäuren oder Lactonen sein. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Polyesterpolyole werden in an sich bekannter Weise durch Polykondensation aus aliphatischen und / oder aromatischen Polycarbonsäuren mit 4 bis 50 Kohlenstoffatomen, gegebenenfalls aus deren Anhydriden sowie gegebenenfalls aus deren niedermolekularen Estern, inklusive Ringestern hergestellt, wobei als Umsetzungskomponente überwiegend niedermolekulare Polyole mit 2 bis 50 Kohlenstoffatomen zum Einsatz kommen. Beispiele für geeignete Alkohole sind dabei Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester oder Mischungen davon, wobei Hexandiol(1,6), sowie die C7-C20 Diole, und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimethylolbenzol oder Trishydroxyethylisocyanurat oder Mischungen davon eingesetzt werden. Besonders bevorzugt werden Diole eingesetzt, ganz besonders bevorzugt Butandiol(1,4) und Hexandiol(1,6), ganz besonders bevorzugt Hexandiol(1,6).

Als Dicarbonsäuren können dabei beispielsweise Phthalsäure, Isophthalsäure, Therephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure, Fettsäure sowie Dimerfettsäuren und/oder 2,2-Dimethylbernsteinsäure eingesetzt werden. Als Säurequelle können auch die entsprechenden Anhydride verwendet werden.

Es können zusätzlich auch Monocarbonsäuren, wie Benzoesäure und Hexancarbonsäure Ölsäure, Rizinusöle, mit verwendet werden.

Bevorzugte Säuren sind aliphatische oder aromatische Säuren der vorstehend genannten Art. Besonders bevorzugt sind dabei aliphatische Säuren, besonders bevorzugt mit mehr als 10 Kohlenstoffatomen.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure oder Hydroxystearinsäure oder Mischungen davon. Geeignete Lactone sind Caprolacton, Butyrolacton oder Homologe oder Mischungen davon. Bevorzugt ist dabei Caprolacton.

Als Polyolkomponente (bb) können Hydroxylgruppen aufweisende Polycarbonate, beispielsweise Polycarbonatpolyole, bevorzugt Polycarbonatdiole, eingesetzt werden. Diese können durch Reaktion von Kohlensäurederivaten, wie Diphenylcarbonat, Dimethylcarbonat oder Phosgen mittels Polykondensation mit Polyolen, bevorzugt Diolen, erhalten werden.

Beispiele hierfür geeigneter Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A, 1,10-Decandiol, 1,12-Dodecandiol oder lactonmodifizierte Diole der vorstehend genannten Art oder Mischungen davon.

Bevorzugt enthält die Diolkomponente dabei von 40 Gewichtsprozent bis 100 Gewichtsprozent Hexandiol, vorzugsweise 1,6-Hexandiol und/oder Hexandiolderivate. Solche Hexandiolderivate basieren auf Hexandiol und können neben endständigen OH-Gruppen Ester- oder Ethergruppen aufweisen. Derartige Derivate sind beispielsweise durch Reaktion von Hexandiol mit überschüssigem Caprolacton oder durch Veretherung von Hexandiol mit sich selbst zum Di- oder Trihexylenglykol erhältlich. Die Menge dieser und anderer Komponenten, werden im Rahmen der vorliegenden Erfindung in bekannter Weise derart gewählt, dass die Summe 100 Gewichtsprozent nicht überschreitet, insbesondere 100 Gewichtsprozent ergibt. Bevorzugt enthält das Polyesterpolyol eine Säure bzw. ein Anhydrid mit > 20 Kohlenstoffatomen bevorzugt zu > 40 Gew.-%.

Hydroxylgruppen aufweisende Polycarbonate, insbesondere Polycarbonatpolyole, sind bevorzugt linear gebaut. Besonders bevorzugt wird ein Polycarbonatdiol auf Basis von 1,6-Hexandiol verwendet.

Ebenfalls können als Polyolkomponente (bb) Polyetherpolyole eingesetzt werden. Diese führen jedoch in der Regel zu Polymeren mit einer geringeren Dielektrizitätskonstanten. Beispielsweise eignen sich Polytetramethylenglykolpolyether wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden. Ein geeignetes Polyetherpolyol ist auch 3-Methyl-1,5-Pentandiol und eine davon ausgehende Polymervariante mit höherem Molgewicht.

Auch hydroxyfunktionelles Oligobutadien, hydriertes hydroxyfunktionelles Oligobutadien, hydroxyfunktionelle Siloxane, Glycerin oder TMP-monoallylether können allein oder in beliebiger Mischung eingesetzt werden.

Des Weiteren können Polyetherpolyole mittels alkalischer Katalyse oder mittels Doppelmetallcyanidkatalyse oder gegebenenfalls bei stufenweiser Reaktionsführung mittels alkalischer Katalyse und Doppelmetallcyanidkatalyse aus einem Startermolekül und Epoxiden, bevorzugt Ethylen-und/oder Propylenoxid hergestellt und weisen endständige Hydroxylgruppen auf. Eine Beschreibung von Doppelmetallcyanid-Katalysatoren (DMC-Katalyse) findet sich zum Beispiel in der Patentschrift US 5,158,922 und der Offenlegungsschrift EP 0 654 302 A1.

Als Starter kommen hierbei die dem Fachmann bekannten Verbindungen mit Hydroxyl- und/oder Aminogruppen, sowie Wasser in Betracht. Die Funktionalität der Starter beträgt hierbei mindestens 2 und höchstens 6. Selbstverständlich können auch Gemische von mehreren Startern verwendet werden. Des Weiteren sind als Polyetherpolyole auch Gemische von mehreren Polyetherpolyolen einsetzbar.

Geeignete Polyolkomponenten (bb) sind auch Esterdiole wie α-Hydroxybutyl-ε-hydroxy-capronsäureester, ω-Hydroxyhexyl-γ-hydroxybuttersäure-ester, Adipinsäure-(β-hydroxyethyl)ester oder Terephthalsäurebis(β-hydroxyethyl)-ester.

Ferner können auch monofunktionelle Verbindungen mit eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol oder 1-Hexadecanol oder Mischungen davon.

Weniger bevorzugt können zusätzlich Kettenverlängerer bzw. Vernetzungsmittel der Polyolkomponente (bb) anteilig zugesetzt werden. Hierbei werden bevorzugt Verbindungen mit einer Funktionalität von 2 bis 3 und einem Molekulargewicht von 62 bis 500 verwendet. Es können aromatische oder aliphatische aminische Kettenverlängerer wie zum Beispiel Diethyltoluoldiamin (DETDA), 3,3'-Dichloro-4,4'-diamino-diphenylmethan (MBOCA), 3,5-Diamino-4-chloro-isobutylbenzoat, 4-Methyl-2,6-bis(methylthio)-1,3-diaminobenzol (Ethacure 300), Trimethylenglykol-di-p-aminobenzoat (Polacure 740M) und 4,4'-Diamino-2,2'-dichloro-5,5'-diethyldi-phenylmethan (MCDEA) verwendet werden. Besonders bevorzugt sind MBOCA und 3,5-Diamino-4-chloro-isobutylbenzoat. Erfindungsgemäß geeignete Komponenten zur Kettenverlängerung sind organische Di- oder Polyamine. Beispielsweise können Ethylendiamin, 1,2- Diaminopropan, 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, Diaminodicyclohexylmethan oder Dimethylethylendiamin oder Mischungen davon eingesetzt werden.

Darüber hinaus können auch Verbindungen, die neben einer primären Aminogruppe auch sekundäre Aminogruppen oder neben einer Aminogruppe (primär oder sekundär) auch OH-Gruppen aufweisen, eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1-methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Oftmals haben diese einen thixotropen Effekt auf Grund ihrer hohen Reaktivität, so dass die Rheologie so verändert wird, dass das Gemisch auf dem Substrat eine höhere Viskosität hat. Als nicht aminische Kettenverlängerer werden oftmals beispielsweise 2,2'-Thiodiethanol, Propandiol-1,2, Propandiol-1,3, Glycerin, Butandiol-2,3, Butandiol-1,3, Butandiol-1,4, 2-Methylpropandiol-1,3, Pentandiol-1,2, Pentandiol-1,3, Pentandiol-1,4, Pentandiol-1,5, 2,2-Dimethyl-propandiol-1,3, 2-Methylbutandiol-1,4, 2-Methylbutandiol-1,3, 1,1,1-Trimethylolethan, 3-Methyl-1,5-Pentandiol, 1,1,1-Trimethylolpropan, 1,6-Hexandiol, 1,7-Heptandiol, 2-Ethyl-1,6-Hexandiol, 1,8-Octandiol, 1,9-Nonandiol, 1,10-Decandiol 1,11-Undecandiol, 1,12-Dodecandiol, Diethylenglykol, Triethylenglykol, 1,4-Cyclohexandiol, 1,3-Cyclohexandiol und Wasser verwendet.

Als Polyolkomponente (bb) kann auch eine Mischung der obigen Komponenten verwendet werden.

Besonders bevorzug haben die Polyisocyanatkomponente (aa) und die Polyolkomponente (bb) niedrige Gehalte an freiem Wasser, Restsäuren und Metallgehalten. Bevorzugt beträgt der Restwassergehalt der Polyolkomponente (bb) < 1 Gew.-% besonders bevorzugt < 0.7 Gew.-% (bezogen auf b)). Der Restsäuregehalt der Polyolkomponente (bb) ist bevorzugt < 1 Gew.-%, besonders bevorzugt < 0.7 Gew.-% (bezogen die Polyolkomponente (bb)). Die Restmetallgehalte, verursacht beispielsweise durch Reste von Katalysatorbestandteilen, die bei der Herstellung der Edukte verwendet werden, sollten bevorzugt kleiner als 1000 ppm sein und weiter bevorzugt kleiner als 500 ppm, bezogen auf die Polyisocyanatkompomente (aa) bzw. die Polyolkomponente (bb), sein.

Das Verhältnis von Isocyanat reaktiven Gruppen zu Isocyanat Gruppen kann in der Mischung von 1:3 bis 3:1, vorzugsweise von 1:1,5 bis 1,5:1 besonders bevorzugt von 1:1,3 bis 1,3:1 und ganz besonders bevorzugt von 1:1,02 bis 1:0,95 betragen.

Die Reaktionsmischung ("Mischung") kann neben den Verbindungen (aa) und (bb) zusätzlich auch Hilfs- und Zusatzstoffe enthalten. Beispiele für solche Hilfs- und Zusatzstoffe sind Vernetzer, Verdicker, Lösungsmittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe Rheologieverbesserer, Weichmacher, Entgasungs- und Entschäumungshilfsmittel, Benetzungsadditive und Katalysatoren sowie Füllstoffe. Besonders bevorzugt enthält die Mischung Benetzungsadditive.

Üblicherweise ist das Benetzungsadditiv in einer Menge von 0,05 bis 1,0 Gew.-% in der Mischung enthalten. Typische Benetzungsadditive sind beispielsweise von der Firma Altana erhältlich (Byk Additive wie etwa: polyestermodifizierten Polydimethylsiloxans, polyethermodifizierten Polydimethylsiloxan oder Acrylat-Copolymeren, sowie beispielsweise $C_6F_{13}$-Fluortelomere).

Vorzugsweise umfasst die Mischung Füllstoffe mit einer hohen Dielektrizitätskonstante. Beispiele hierfür sind keramische Füllstoffe, insbesondere Bariumtitanat, Strontiumtitanat, Kupfertitanat, Calciumtitanat, Titandioxid und piezoelektrische Keramiken wie Quarz oder Bleizirkoniumtitanat, und Mischoxide aller oben erwähnten Verbindungen sowie organische Füllstoffe, insbesondere solche mit einer hohen elektrischen Polarisierbarkeit, beispielsweise Phthalocyanine, Poly-3-Hexylthiophen. Durch den Zusatz dieser Füllstoffe kann die Dielektrizitätskonstante des Polyurethan Films erhöht werden.

Außerdem ist eine höhere Dielektrizitätskonstante auch durch das Einbringen elektrisch leitfähiger Füllstoffe unterhalb der Perkolationsschwelle erzielbar. Beispiele für derartige Stoffe sind außer Metallen wie z.B. Silber, Aluminium und Kupfer, Ruß, Graphit, Graphen, Fasern, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen. Hier sind solche Rußtypen mit besonders hoher BET-Oberfläche bevorzugt.

Im Rahmen der vorliegenden Erfindung können Additive zur Erhöhung der Dielektrizitätskonstanten und / oder der elektrischen Durchschlagsfeldstärke auch noch nach der Verfilmung von Polyurethanen zugesetzt werden. Dies kann beispielsweise durch Erzeugung einer oder mehrerer weiterer Schichten oder durch Durchdringung des Polyurethan-Films beispielsweise durch Eindiffundieren erfolgen.

Als Lösungsmittel können wässrige sowie organische Lösemittel verwendet werden.

Vorzugsweise kann ein Lösungsmittel verwendet werden, dass einen Dampfdruck bei 20 °C von > 0,1 mbar und ≤ 200 mbar, bevorzugt > 0,2 mbar und < 150 mbar und besonders bevorzugt > 0,3 mbar und < 120 mbar aufweist. Hierbei ist besonders vorteilhaft, dass die erfindungsgemäßen Filme auf einer Rollenbeschichtungsanlage hergestellt werden können.

In einer ganz besonders bevorzugten Ausführungsform wird der Polymerfilm gemäß WO 2014/001272 im Rolle zu Rolle Verfahren unter Zugabe von organischen Lösemitteln und einem Benetzungsadditiv hergestellt. Die Reaktionsmischung wird hierbei beispielsweise mit einer Nassfilmdicke von 10 bis 300 μm, bevorzugt von 15 bis 150 μm, weiter bevorzugt von 20 bis 120 μm und ganz besonders bevorzug von 20 bis 80 μm aufgetragen.

Die Erfindung wird im Folgenden anhand der nachfolgenden Beispiele näher erläutert.

Beispiele:

Sofern nicht abweichend gekennzeichnet, beziehen sich alle Prozentangaben auf das Gewicht.

Sofern nicht abweichend vermerkt, würden alle analytischen Messungen bei Temperaturen von 23 °C unter Normalbedingungen durchgeführt.

Methoden:

NCO-Gehalte wurden, wenn nicht ausdrücklich anders erwähnt, volumetrisch gemäß DIN EN ISO 11909 bestimmt.

Hydroxylzahlen (OHZ in mgKOH/g Substanz) wurden gemäß DIN 53240 (Dezember 1971) bestimmt.

Messungen der Filmschichtdicken wurden mit einem mechanischen Taster der Firma Dr. Johannes Heidenhain GmbH, Deutschland, Dr.-Johannes-Heidenhain-Str. 5, 83301 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 1kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit in [MPa] und der Bruchdehnung in [%] noch die Spannung in [MPa] bei 100% und 200% Dehnung bestimmt.

Die Bestimmung der Spannungsrelaxation ("Creep") gemäß DIN 53 441 wurde auf der Zugmaschine Zwicki ausgeführt; die Instrumentierung entspricht dabei dem Versuch zur Bestimmung der bleibenden Dehnung. Als Probekörper wurde hierbei eine streifenförmige Probe der Dimension 60 x 10 $mm^2$ eingesetzt, die mit einem Klemmenabstand von 50 mm eingespannt wurde. Nach einer schlagartigen Deformation auf 55 mm wurde diese Deformation für die Dauer von 30 min konstant gehalten und während dieser Zeit der Kraftverlauf bestimmt. Die Spannungsrelaxation nach 30 min

ist der prozentuale Abfall der Spannung, bezogen auf den Anfangswert direkt nach der Deformation auf 55 mm.

Die Messungen der Dielektrizitätskonstante gemäß ASTM D 150-98 wurden mit einem Messaufbau der Firma Novocontrol Technologies GmbH & Co. KG, Obererbacher Straße 9, 56414 Hundsangen, Deutschland (Messbrücke : A1pha-A Analyzer, Messkopf: ZGS Active Sample Cell Test Interface) mit einem Durchmesser der Probekörper von 20 mm ausgeführt. Untersucht wurde dabei ein Frequenzbereich von $10^7$ Hz bis $10^{-2}$ Hz. Als Maß für die Dielektrizitätskonstante des untersuchten Materials wurde der Realteil der Dielektrizitätskonstante bei 10-0,01 Hz gewählt.

Die Bestimmung des elektrischen Wiederstandes geschah mittels eines Laboraufbaus der Fa. Keithley Instruments (Keithley Instruments GmbH, Landsberger Straße 65, D-82110 Germering Germany) Modell Nr.: 6517 A und 8009 gemäß ASTM D 257, einer Methode zur Bestimmung des Isolationswiderstandes von Werkstoffen.

Die Bestimmung der Durchbruchsfeldstärke gemäß ASTM D 149-97a wurde mit einer Hochspannungsquelle Modell hypotMAX der Firma Associated Research Inc, 13860 W Laurel Drive, Lake Forest, IL 600045-4546, USA und einem eigenkonstruierten Probenhalter durchgeführt. Der Probenhalter kontaktiert die homogen dicken Polymerproben mit nur geringer mechanische Vorbelastung und verhindert, dass der Bediener in Kontakt mit der Spannung kommt. Die nicht vorgespannte Polymerfolie wird in diesem Aufbau mit steigender Spannung statisch belastet, bis ein elektrischer Durchbruch durch die Folie erfolgt. Messergebnis ist die beim Durchbruch erreichte Spannung, bezogen auf die Dicke der Polymerfolie in [V/μm]. Es werden je Folie 5 Messungen ausgeführt und der Mittelwert angegeben.

Die Knotendichte der Elastomere wurde wie vorstehend erläutert bestimmt (siehe auch EP 1 556 429 B1)

Verwendete Substanzen und Abkürzungen:

| | |
|---|---|
| Desmodur® N100 | Biuret auf Basis von Hexamethylendiisocyanat, NCO-Gehalt 220 ± 0,3 % (nach DIN EN ISO 11 909), Viskosität bei 23 °C 10000 ± 2000 mPa·s, Bayer MaterialScience AG, Leverkusen, DE |
| Desmodur® N75/MPA | Desmodur® N100 (75 Gew.-%) in Methoxypropylacetat (25 Gew.-%) |
| Tib Kat 220 | Butylzinntris-(2-ethylhexanoat), Fa. Tib Chemicals AG, Mannheim |
| P200H/DS | Polyesterpolyol auf Basis von 44,84Gew.-% 1,6-Hexandiol und 55,16 Gew.-% Phthalsäureanhydrid, Molgewicht 2000 g/mol, Bayer MaterialScience AG, Leverkusen, DE |
| DBTDL | Dibutyl-Zinn-Dilaurat der Firma E-Merck KGaA, Frankfurter Str. 250, D-64293 Darmstadt, Germany |
| Desmophen 250 | Polyetherpolyol der Fa. Bayer MaterialScience AG, 868 mgKOH/g, Funktionalität 3 |
| Desmophen 49WB80 | Polyetherpolyol der Fa. Bayer MaterialScience AG, 415 mgKOH/g, Funktionalität 2 |
| N-2-Hydroxyethyl)-N'- | Methyl-4-Nitroanilin und N,N-Bis-(2-Hydroxyethyl)-4-Nitroanilin; Herstellung gemäß Adv. Funct. Mater. 2012, 22, 3958 sowie Adv. Funct. Mater. 2011, 21, 4589. |
| Hostaphan RN 2SLK: | Trennfolie der Firma Mitsubishi auf Basis Polyethylenterephthalat mit Silikonbeschichtung. Es wurde eine 300 mm breite Folie verwendet. |

**Herstellung der Filme**

Alle Filme wurden mit dem Isocyanat N100 in gleicher Weise hergestellt; Unterschiede ergaben sich nur in der Herstellung der Laborfilme und der Filme im Rolle-zu-Rolle-Prozess. Nachfolgend werden die beiden Herstellungsarten exemplarisch beschrieben.

**Herstellung des Dipol-funktionalisierten Polyisocyanats ("Additiv"):**

74,10 Gew.-Teile des Polyisocyanats Desmodur® N75 MPA mit einer Funktionalität (Funktionelle NCO Gruppen pro Molekül) von 3,8 wurde mit 19 Gew.-Teilen N-2-Hydroxyethyl)-N'-Methyl-4-Nitroanilin der Funktionalität 1(Funktionelle OH Gruppen pro Molekül) mit 0,023 Gew.-Teilen Tibkat 220 für 10 h bei 60 °C unter Rühren umgesetzt. Der NCO Gehalt betrugt 8 Gew.-%, so dass 0,8 NCO Gruppen mit OH-Gruppen abreagiert sind. Dies entspricht einer NCO Funktionalität des Additivs von 3,0; dies entspricht einem kompletten Umsatz der berechneten Mengen von NCO und

OH. Das Additiv ist flüssig bei Raumtemperatur.

**Herstellung eines Films im Labor:**

Es wurden 21,39 Gew.-Teile Desmodur N100, mit einer Polyolmischung aus 0,01 Gew.-Teilen DBTL sowie 100 Gew.-Teilen P200H/DS und der entsprechenden Menge Additiv gemäß Tabelle 1 mit einander umgesetzt (Das Verhältnis in der Tabelle bezeichnet das Gew.-Verhältnis der NCO Komponenten aus der Mischung von Additv und Desmodur N100 zueinander). Das Isocyanat (Desmodur N100) wurde bei 40 °C eingesetzt, die Polyolabmischung (Polyesterpolyol mit TIB Kat 220) bei 80 °C. Das Verhältnis von NCO zu OH Gruppen lag bei 1,07. Es wurde auf die Hostaphan Folie gegossen und 1 h bei 100°C im Heizschrank getrocknet.

**Bewertung der Beispiele und Vergleichsbeispiele:**

Tabelle 1 enthält alle Ergebnisse. Wenn das Additiv in zu hoher Konzentration zugegeben wird, und die Knotendichte des Netzwerkes zu stark absinkt, nimmt der Creep zu stark zu. Ebenso erzeugt ein kovalent angebundener Dipol gemäß WO 2012/038093 einen zu hohen Creep sowie auch einen zu hohen Modul. Die Knotendichte von 0,114 mol/kg ist somit zu niedrig. Alle anderen Eigenschaften zeigen, dass sich durch das Additiv keine Eigenschaft negativ beeinflusst wird und die entscheidende Dielektrizitätskonstante von 6,19 des unmodifizierten Systems ohne Additiv auf 9,32 ansteigt. Dies entspricht eine Steigerung um 50%. Da sowohl Durchbruchsspannung und Widerstand konstant bleiben, der Modul aber von 3,6 auf 2,9 gesenkt werden kann, erhöht sich die gesamte, aktorische Auslenkung gemäß der eingangs beschriebenen Gleichung sogar um 94%. Positiv ist ferner, dass die Energiedichte durch die Modifizierung nicht erniedrigt wird, so dass die Energiespeicherung auf einem hohen Niveau ca. viermal so groß wie bei Silikonelastomeren ist. Das Beispiel "Referenz" ist ohne jegliches Additiv hergestellt. V5 ist ein Beispiel, bei dem das Additiv nicht vorher mit dem Isocyanat umgesetzt wurde.

Alle Filme ließen sich fehlerfrei herstellen. Eine Darstellung im Rolle-zu-Rolle Verfahren gemäß WO 2014/001272, Beispiel 4 unter Zugabe von Lösemitteln und einem Benetzungsadditiv auf einem PP-beschichtetem Papier war ebenfalls problemlos möglich.

| Beispiel | Zusammensetzung | Knotendichte [mol/kg] | Dehnung max. [%] | Spannung 025% [N/mm²] | E' ( 0%) [MPa] | Creep 10% Deformation nach 30 min [%] | Epsilon' bei 1Hz | VolumenWiderstand [Ohm cm] | Durchbruchsfeldstärke [V/µm] | $S_z$ (rel). (1 Hz) | Spez. Energie [J/cm³] |
|---|---|---|---|---|---|---|---|---|---|---|---|
| E4 | N100 + Additiv (30:70)/P 200 H DS | 0,1140 | 327,7 | 0,535 | 3,0071 | 18,266 | 10,05 | 1,113E+14 | 97,20 | 1,25 | 0,3838 |
| E3 | N100 + Additiv (50:50)/P 200 H DS | 0,1664 | 285,2 | 0,556 | 2,9616 | 9,820 | 9,32 | 9,525E+13 | 93,39 | 1,15 | 0,3637 |
| E2 | N100 + Additiv (60:40)/P 200 H DS | 0,1858 | 243,4 | 0,587 | 2,8960 | 5,531 | 8,93 | 1,051E+14 | 92,44 | 1,01 | 0,3414 |
| E1 | N100 + Additiv (90:10)/P 200 H DS | 0,2283 | 271,8 | 0,657 | 3,3332 | 1,945 | 8,56 | 7,733E+13 | 97,99 | 1,03 | 0,3664 |
| Referenz | N100/P 200 H DS | 0,2379 | 132,5 | 0,695 | 3,5115 | 0,615 | 6,19 | 9,355E+13 | 106,69 | 0,77 | 0,3860 |
| V5 | N100/P200H DS mit 10 Gew.% N,N-Bis-(2-Hydroxyethyl)-4-Nitroanilin auf Gesamt | Nicht bestimmt | 231,4 | 0,851 | 4,75 | 15,21 | 9,33 | 2,449E+14 | 94,37 | 0,79 | 0,3845 |
| V6 | - | Nicht bestimmt | 460 | 0,175 | 0,9318 | 7,437 | 2,45 | 1,415E+15 | 98,43 | 1 | 0,1050 |

$S_z$ (rel) ist eine normierte Bewertung der aktorischen Auslenkung; Normiert wurde bei gleichen Berechnungen die aktorische Auslenkung der oben genannte Proben auf die der Wacker Siliconfolie RT 625®. Die Auslenkung wurde gemäß Gleichung 1 und die Energiedichte gemäß der Gleichung $\omega_{el} = 1/2\ \varepsilon_0 \varepsilon_r E^2$ berechnet.

Ein Silikon der Fa. Wacker Chemie Burghausen, Elastosil® RT 625 ist als zusätzlicher Vergleich 6 eingefügt. Die Energiedichte für elektromechanische Energiewandlung ist jedoch im Falle des Silikons zu niedrig.

**Patentansprüche**

1. Verfahren zur Herstellung eines dielektrischen Polyurethan-Polymers umfassend die Schritte:

    (a) Erzeugung eines Dipol-funktionalisierten Polyisocyanats durch Umsetzung eines Polyisocyanats mit NCO-Funktionalität von > 2,0 mit einer Dipol-Verbindung der allgemeinen Formel (I)

    $$(Z)\text{-}(R)_n\text{-}(D)\text{-}X\text{-}(A)_m \qquad \text{(Formel I)}$$

    in der
    Z eine funktionelle Gruppe mit wenigstens einem Zerewitinoff-aktiven Wasserstoffatom,
    X ein organischer Rest mit einem delokalisierten Elektronensystem,
    A eine Elektronenakzeptorfunktionalität, ausgewählt aus der Gruppe bestehend aus -NO2, -CN, -F, -Cl, -CF3,-OCF3, Cyanovinyl-, Dicyanovinyl-, oder Tricyanovinyl-Resten,
    D eine Elektronendonorfunhtionalität, ausgewählt aus der Gruppe bestehend aus-O-, -S- oder -N(B)-, wobei B Wasserstoff oder ein linearer oder verzweigter Alkylrest mit 1 bis 16 Kohlenstoffatomen ist,
    R ein Alkylenrest mit 1 bis 16 Kohlenstoffatomen repräsentiert, wobei n = 0 oder 1 und m = 1, 2, 3 oder 4 ist;
    (b) anschließende Umsetzung des nach Schritt (a) erhaltenen Dipol-funktionalisierten Polyisocyanats mit

        (aa) einer Polyisocyanatkomponente und
        (bb) einer Polyolkomponente.

2. Verfahren nach Anspruch 1, **dadurch gekennzeichnet, dass** der Gehalt des Dipol-funktionalisierten Polyisocyanats bezogen auf die Gesamtmasse aus Dipol-funktionalisierten Polyisocyanat, Polyisocyanatkomponente und Polyolkomponente 0,1 bis 50 Gew.-% beträgt, insbesondere 1 bis 20 Gew.-%, bevorzugt 5 bis 10 Gew.-%.

3. Verfahren nach Anspruch 1 oder 2, **dadurch gekennzeichnet, dass** Z für OH, COOH, SH, $NH_2$ steht.

4. Verfahren nach einem der vorstehenden Ansprüche, **dadurch gekennzeichnet, dass** R ein Alkylenrest mit 2 bis 8 Kohlenstoffatomen ist, insbesondere mit 2 oder 3 Kohlenstoffatomen.

5. Verfahren nach einem der vorstehenden Ansprüche, **dadurch gekennzeichnet, dass** das Polyisocyanat zur Herstellung des Dipol-funktionalisierten Polyisocyanats und die Polyisocyanatkomponente (aa) unabhängig voneinander eine NCO-Funktionalität von 2,6 bis 4,2 besitzen, insbesondere von 2,8 bis 4,0, bevorzugt von 2,8 bis 3,8.

6. Verfahren nach einem der vorstehenden Ansprüche, **dadurch gekennzeichnet, dass** das Dipol-funktionalisierte Polyisocyanat eine NCO-Funktionalität von wenigstens 2,0 besitzt, insbesondere von 2,1 bis 4,0, bevorzugt von 2,5 bis 3,0.

7. Verfahren nach einem der vorstehenden Ansprüche, **dadurch gekennzeichnet, dass** die Polyolkomponente ausgewählt ist aus der Gruppe bestehend aus Polyesterpolyolen, Polycarbonatpolyolen und Polyestercarbonatpolyolen.

8. Verfahren nach einem der vorstehenden Ansprüche, **dadurch gekennzeichnet, dass** die Dipol-Verbindung der allgemeinen Formel II

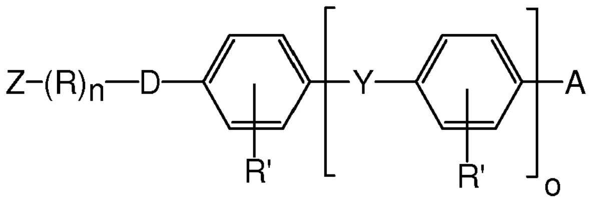

(Formel II)

entspricht, in der
A, D, R, Z und n die oben angegebene Bedeutung haben,
R'jeweils unabhängig ausgewählt ist aus der Gruppe bestehend aus Wasserstoff, linearen oder verzweigten Alkylresten mit 1 bis 18 Kohlenstoffatomen sowie aromatischen Resten, Y eine chemische Bindung repräsentiert oder ausgewählt ist aus der Gruppe bestehend aus cis- oder trans-1,2-Ethendiyl, Ethindiylresten, einer Diazogruppe oder einer 1,2-Azomethindiylgruppe, sowie
o = 0 bis 10, insbesondere 1, 2 oder 3 ist.

**9.** Verfahren nach einem der vorstehenden Ansprüche, **dadurch gekennzeichnet, dass** das nach Schritt (a) erhaltene Dipol-funktionalisierte Polyisocyanat

• unmittelbar mit der Polyisocyanatkomponente (aa) und der Polyolkomponente (bb) oder
• zunächst mit der Polyolkomponente (bb) oder einer Teilmenge der Polyolkomponente (bb) umgesetzt und das dabei erhaltene Präpolymer anschließend mit der Polyisocyanatkomponente (aa) sowie gewünschtenfalls der restlichen Teilmenge der Polyolkomponente (bb)
umgesetzt wird.

**10.** Dielektrisches Polyurethan-Polymer erhältlich oder erhalten nach einem der Ansprüche 1 bis 9.

**11.** Dielektrisches Polyurethan-Polymer nach Anspruch 10, **dadurch gekennzeichnet, dass** es eine, mehrere oder sämtliche der folgenden Eigenschaften aufweist:

a. Einen Zugmodul von < 5 MPa bei 25% Dehnung nach DIN 53 504;
b. eine Bruchdehnung von > 20% nach DIN 53 504, insbesondere > 50%, bevorzugt > 80%;
c. eine Spannungsrelaxation (Creep) gemäß DIN 53 441 bei 10% Deformation nach 30 min nach DIN 53 441 von < 20%, insbesondere < 15%, bevorzugt < 10%;
d. eine Durchbruchfeldstärke von > 40 V/$\mu$m nach ASTM D 149-97a, insbesondere > 60 V/$\mu$m, bevorzugt > 80 V/$\mu$m;
e. einen elektrischen Widerstand von > 1,0 E10 Ohm m nach ASTM D 257, insbesondere > 1,0 E11 Ohm m, bevorzugt > 5,0 E11 Ohm m;
f. eine Dielektrizitätskonstante von > 8 bei 0,01 - 1 Hz nach ASTM D 150-98;
g. eine Knotendichte > 0,13 mol/kg und < 1,5 mol /kg;
h. eine Energiedichte > 0,2 J/$cm^3$;
i. eine Dielektrizitätskonstante nach ASTM D 150-98 bei 1 Hz von wenigstens 8, insbesondere von 8 bis 15;
j. eine elektrische Durchschlagfestigkeit von wenigstens 80 V/$\mu$m nach ASTM D 149-97a, insbesondere von 80 bis 230;
k. einen elektrischen Volumenwiderstand von wenigstens 1 E11 V/cm nach ASTM D 257, insbesondere von 1,0 E11 V/cm bis 8,0 E16 V/cm;
l. einen Creep gemäß DIN 53 441 von wenigstens 12%, insbesondere von 0.15 bis 12.

**12.** Verwendung eines dielektrischen Polyurethan-Polymers nach Anspruch 10 oder 11 oder eines Blends aus diesem dielektrischen Polyurethan-Polymer und wenigstens einem weiteren Polymer ausgewählt aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten, als Dielektrikum, als elastisches Dielektrikum, als Aktuator, als künstlicher Muskel, als Dielektrikum für flexible elektronische Bauteile, insbesondere Kondensatoren, insbesondere weiche Kondensatoren.

**13.** Formkörper in Form eines Dielektrikum, eines künstlichen Muskels und/oder eines Aktuators, wie vorgestreckte

Aktuatoren und/oder Stapelaktuatoren, wobei der Formkörper ein dielektrisches Polyurethan-Polymer nach Anspruch 10 oder 11 oder ein Blend aus diesem dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

**14.** Elektrochemischer Wandler, enthaltend ein dielektrisches Polyurethan-Polymer nach Anspruch 10 oder 11 oder oder ein Blend aus diesem dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Europäisches Patentamt
European Patent Office
Office européen des brevets

# EUROPÄISCHER RECHERCHENBERICHT

Nummer der Anmeldung
EP 14 19 9788

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A,D | WO 2012/038093 A1 (FRAUNHOFER GES FORSCHUNG [DE]; KRUEGER HARTMUT [DE]; KUSSMAUL BJOERN [])<br>29. März 2012 (2012-03-29)<br>* Ansprüche 1,4 *<br>----- | 1-14 | INV.<br>C08G18/78<br>C08G18/80<br>C08G18/24<br>C08G18/32<br>C08G18/42<br>H01L41/00 |
| A | FRUBING P ET AL: "Relaxation behaviour of thermoplastic polyurethanes with covalently attached nitroaniline dipoles", POLYMER, ELSEVIER SCIENCE PUBLISHERS B.V, GB,<br>Bd. 43, Nr. 9, 1. April 2002 (2002-04-01), Seiten 2787-2794, XP004339245,<br>ISSN: 0032-3861, DOI: 10.1016/S0032-3861(02)00075-7<br>* 2. Sample preparation and experimental procedures;<br>Seite 2788; Abbildung 1 *<br>----- | 1-14 | |

| RECHERCHIERTE SACHGEBIETE (IPC) |
|---|
| C08G<br>H01L |

Der vorliegende Recherchenbericht wurde für alle Patentansprüche erstellt

1

| Recherchenort | Abschlußdatum der Recherche | Prüfer |
|---|---|---|
| München | 28. Mai 2015 | Bergmeier, Martin |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 14 19 9788

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-05-2015

| Im Recherchenbericht angeführtes Patentdokument | Datum der Veröffentlichung | Mitglied(er) der Patentfamilie | Datum der Veröffentlichung |
|---|---|---|---|
| WO 2012038093 A1 | 29-03-2012 | DE 102010046343 A1 | 29-03-2012 |
| | | EP 2619250 A1 | 31-07-2013 |
| | | JP 2013539803 A | 28-10-2013 |
| | | KR 20140043883 A | 11-04-2014 |
| | | US 2013253146 A1 | 26-09-2013 |
| | | WO 2012038093 A1 | 29-03-2012 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 0106575 A
- WO 2012038093 A
- WO 2012038093 A1
- EP 1556429 B1
- US 5158922 A
- EP 0654302 A1
- WO 2014001272 A


### In der Beschreibung aufgeführte Nicht-Patentliteratur


- **VON FEDERICO CARPI.** Dielectric Elastomers as Electromechanical Transducers. Elsevier, 314
- **R. PELRINE.** *Science,* 2000, vol. 287 (5454), 837
- **VON CHRISTIAN GRAF ; JÜRGEN MAAS.** Energy harvesting cycles based on electro active polymers. *proceedings of SPIE Smart structures,* 2010, vol. 7642, 764217
- **Q. M. ZHANG ; H. LI ; M. POH ; F. XIA ; Z.-Y. CHENG ; H. XU ; C. HUANG.** An all-organic composite actuator material with a high dielectric constant. *Nature,* 2002, vol. 419, 284-287
- **C. HUANG ; Q. ZHANG.** Fully functionalized high-dielectric-constant nanophase polymers with high electromechanical response. *Adv. Mater,* 2005, vol. 17, 1153
- *DIN 53240,* Dezember 1971
- *Adv. Funct. Mater.,* 2012, vol. 22, 3958
- *Adv. Funct. Mater.,* 2011, vol. 21, 4589